# EUROPEAN PATENT APPLICATION

(11) **EP 0 730 294 A2**
(43) Date of publication of application: **04.09.1996**
(21) Application number: 95118241.9
(22) Date of filing: 20.11.1995
(51) Int. Cl.: H01L 21/58

(54) **Semiconductor device fabricating method of semiconductor device, and die-bonding method of semiconductor device**

(30) Priority: 28.02.1995 JP 39950/95
(71) Applicant: MITSUBISHI DENKI KABUSHIKI KAISHA, Tokyo 100 (JP)
(72) Inventor: Gotoh, Kei, c/o Mitsubishi Denki K.K., Chiyoda-ku, Tokyo 100 (JP)
(74) Representative: KUHNEN, WACKER & PARTNER

(57) **Abstract**

A semiconductor device includes a semiconductor substrate (1a) having a first main surface; and a thermoplastic conductive resin layer (7a) comprising thermoplastic resin including particles comprising conductive material disposed on a first main surface of the semiconductor substrate (1a). Therefore, positional deviation of the semiconductor device with a resin layer while die-bonding the semiconductor device is dispensed with, thereby increasing the fabrication yield. In addition, an apparatus and a process for disposing resin on a package can be omitted, thereby the die-bonding can be performed at a low cost.

## Description

### FIELD OF THE INVENTION

The present invention relates to a semiconductor device, a fabricating method of a semiconductor device, and a die-bonding method of a semiconductor device and, more particularly, to a semiconductor device die-bonded on a package or a carrier, a fabricating method thereof, and a die-bonding method of a semiconductor device.

### BACKGROUND OF THE INVENTION

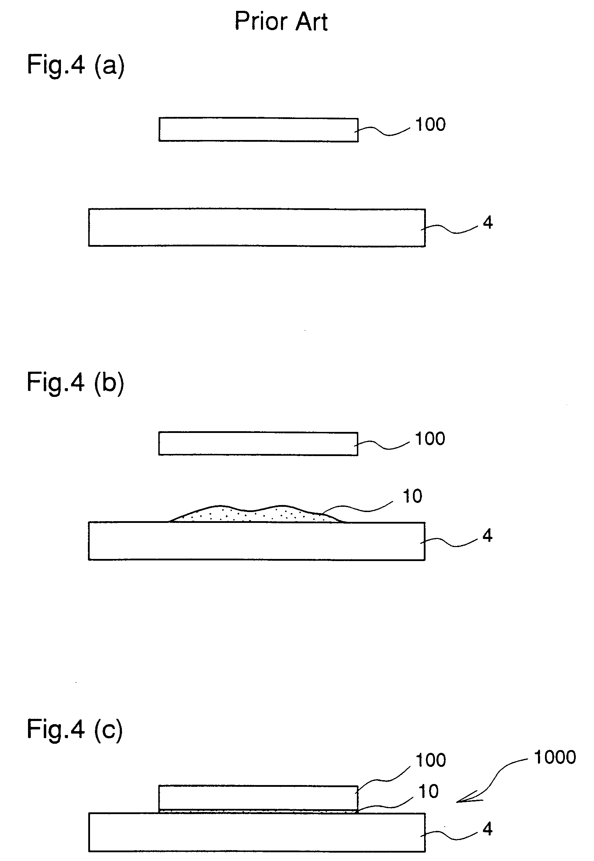

Figure 4(a)-4(c) are diagrams illustrating a prior art die-bonding method of a semiconductor device. In figure 4, numeral 100 designates a semiconductor device which is cut into chip units from a wafer(not shown). The semiconductor device 100 comprises a single or a plurality of semiconductor elements formed on a semiconductor substrate. Numeral 4 designates a die-pad serving as a part of a package for sealing the semiconductor device 100, on which the semiconductor device 100 is fixed. Numeral 10 designates conductive paste comprising epoxy based resin (hereinafter referred to as epoxy based conductive paste), and this includes epoxy based resin, solvent, and conductive filler such as Ag. Numeral 1000 designates a die-bonded semiconductor device comprising the semiconductor device 100 being die-bonded on the die-pad 4.

A description is given of the fabricating method. First of all, as shown in figure 4(a), a semiconductor device 100 and a die-pad 4 are prepared. Next, by a transfer method using stamping, or by potting using a dispense needle, the epoxy based conductive paste 10 is plated to a position on the die-pad where the semiconductor device is to be fixed as shown in figure 4(b), then the semiconductor device 100 is disposed on this paste 10, and the entirety of these is inserted into a cure furnace. The curing is performed at a temperature of about 150°C, and the epoxy based conductive paste 10 is hardened to perform the die-bonding, whereby a die-bonded semiconductor device 1000 as shown in figure 4(c) is obtained.

In the prior art die-bonding method of a semiconductor device constructed as described above, it is necessary to plate the epoxy based conductive paste 10 for each package with controlling the configuration of the epoxy based conductive paste 10 in accordance with the size of the semiconductor device, whereby the mounting method becomes complicated. In addition, while pushing the semiconductor device 100 to the epoxy based conductive paste 10 lightly at the die-bonding, the epoxy based conductive paste 10 crawls up to the surface along the side surface of the semiconductor device 100, and unrequired portions are conducted by the epoxy based conductive paste 10, thereby reducing the fabrication yield of the semiconductor device.

The epoxy based conductive paste 10 includes solvent therein and when the curing is performed placing the semiconductor device 100 on the paste 10, the solvent in the paste 10 is evaporated. Therefore, it may happen that the semiconductor device 100 is corroded by the evaporated solvent. Or the solvent may be re-deposited on the wire bonding pad on the surface of the semiconductor substrate 100. In the latter case, no good wire bonding is performed in the later process.

The solvent included in the epoxy based conductive paste 10 is likely to be evaporated at a room temperature. Therefore, it is difficult to keep the paste 10 at the room temperature.

In addition, it is necessary to perform wire-bonding after placing the semiconductor device 100 on the die-pad 4 of the package, the wire bonding process is usually performed at a temperature of 200 °C, and the anti-heat temperature of epoxy based resin forming the epoxy based conductive paste 10 is low to be about 200 °C. Therefore, it may happen that the epoxy based resin of the paste 10 is dissociated in the wire-bonding process that is performed at the above-described temperature, and the surface of the semiconductor device 100 was contaminated.

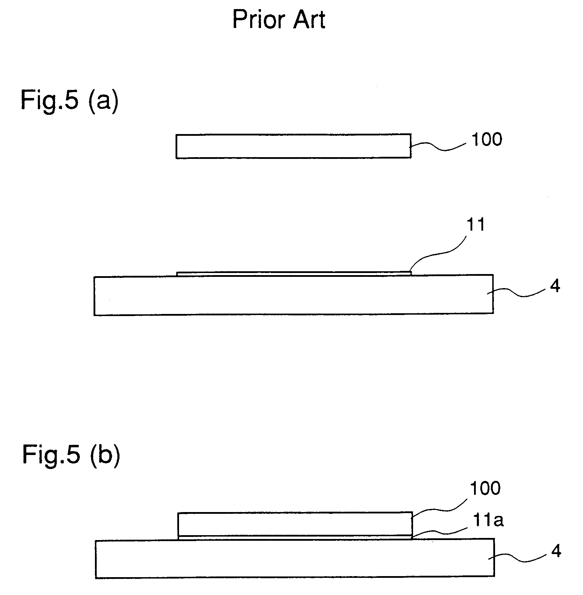

Figures 5(a)-5(b) illustrate another prior art die-bonding method of a semiconductor device which can solve the problems in the prior art example described with reference to figures 4(a)-4(c), which is recited in, for example, Japanese Published Patent Application No.59-117240 and Japanese Published Patent Application No.1-272124. In the figures, the same reference numerals designate the same or corresponding elements as in figure 4. Numeral 11 designates thermoplastic conductive paste. This paste 11 comprises thermoplastic resin, and this includes solvent, and particles comprising conductive material as fillers. In addition, numeral 11a designates a thermoplastic conductive resin layer which has made the solvent evaporated and has been hardened.

In this die-bonding method, first of all, as shown in figure 5(a), the conductive paste 11 comprising thermoplastic resin layer is plated onto a portion on the die-pad 4 where a semiconductor device is to be adhered and this is heated to remove the solvent therein to form thermoplastic conductive resin layer 11a. Further, as shown in figure 5(b), the semiconductor device 100 is mounted thereon, and heating processing is performed to harden the thermoplastic conductive resin layer 11a, thereby bonding the die-pad 4 and the semiconductor device 100.

In this other prior art die-bonding method of a semiconductor device, since the thermoplastic conductive paste 1 comprising thermoplastic resin is used for bonding the semiconductor device 100 onto the die-pad 4 and the solvent in the thermoplastic conductive paste 11 is already removed before the die-bonding of the semiconductor device, the semiconductor device would not be unfavorably affected by the gases which are generated by the evaporation of the solvent. In addition, since the semiconductor device 100 is disposed on the thermoplastic conductive resin layer 11a which has been already hardened, differently from a case where the semiconductor device 100 is mounted on the paste shaped resin, the resin would not crawl up onto the upper surface from the side surface of the semiconductor device 100, thereby increasing the fabrication yield. In addition, since the thermoplastic resin would hardly deform after it is once plated on the die-pad 4 and hardened, its preservation and handling are quite easy. Further, since many thermoplastic resin have heat-resistant temperatures larger than 200 °C, it is possible to arise no dissociation and transformation in the high temperature processing in the later process such as wire bonding by increasing the heat-resistance temperature of the thermoplastic resin.

In the other prior art die-bonding method shown in figure 5, the problem in the prior art die-bonding method of figure 4 is solved.

Japanese Published Patent Application No.59-107528 and Japanese Published Patent Application No.60-52028 disclose methods in which a pellet or a ribbon comprising thermoplastic resin including Ag is put between by a die-pad and a semiconductor chip, and the thermoplastic resin pellet or ribbon is hardened by heat, thereby performing the die-bonding. Also by these methods, the problem in the prior art die-bonding method shown in figure 4 can be solved similarly as in the die-bonding method of a semiconductor device shown in figure 5.

In these other prior art die-bonding methods of a semiconductor device, however, because such as a pellet comprising thermoplastic conductive resin or a thermoplastic conductive resin layer is disposed on the die-pad 4, when there arises while attaching a semiconductor device a positional deviation, i.e., a deviation in the attaching position of the semiconductor device with respect to the position of such as the thermoplastic conductive resin layer and the pellet, it was impossible to perform die-bonding which can provide desired heat radiation property, conductivity, and adhesion intensity, and this results in reduction in the fabrication yield. Although it can be thought of to have a margin for the positional deviation by increasing the sizes of the thermoplastic resin layer and the pellet to prevent reduction in the yield due to such positional deviation, the size of the package then would unfavorably increase more than required and it would become difficult to achieve the miniaturization of the semiconductor package.

In the other prior art die-bonding method of a semiconductor device, it is necessary to provide a process of forming thermoplastic conductive resin layer or disposing such as a pellet comprising thermoplastic conductive resin for respective packages, and therefore, the work is complicated and the productivity is worse. In addition, it is necessary to provide such as an apparatus for plating resin paste or disposing resin pellet in the bonding apparatus, whereby the bonding apparatus would be complicated and expensive.

Since when a paste comprising thermoplastic conductive resin is used, the solvent included in the paste is evaporated after the paste is plated onto the die-pad, the surface of the die-pad, particularly, the surface of the metal pad used for such as wire-bonding would be contaminated by the gases obtained from the evaporation of the solvent, whereby the quality of the semiconductor device is deteriorated and the fabrication yield is lowered.

### SUMMARY OF THE INVENTION

It is an object of the present invention to provide a semiconductor device for which the die-bonding can be performed at high yield, with high reproducibility, and at low cost.

It is another object of the present invention to provide a fabricating method of a semiconductor device in which the die-bonding can be performed at high yield, with high reproducibility, and at low cost.

It is a still another object of the present invention to provide a die-bonding method of a semiconductor device that performs the die-bonding at high yield, with high reproducibility, and at low cost.

Other objects and advantages of the present invention will become apparent from the detailed description given hereinafter; it should be understood, however, that the detailed description and specific embodiment are given by way of illustration only, since various changes and modifications within the scope of the invention will become apparent to those skilled in the art from this detailed description.

According to a first aspect of the present invention, a semiconductor device includes a semiconductor substrate having a first main surface; and a thermoplastic conductive resin layer comprising thermoplastic resin including particles comprising conductive material disposed on the first main surface of the semiconductor substrate. Therefore, positional deviation of the semiconductor device with a resin layer while die-bonding the semiconductor device is dispensed with, thereby increasing the fabrication yield. In addition, an apparatus and a process for disposing resin on a package can be omitted, thereby the die-bonding can be performed at a low cost.

According to a second aspect of the present invention, in the above-described semiconductor device, the semiconductor substrate has an element on a main surface opposite to the first main surface. Therefore, the positional deviation of the semiconductor device with the resin layer for die-bonding is dispensed with, and an apparatus and a process for disposing resin on a package during the die-bonding can be omitted.

According to a third aspect of the present invention, in the above-described semiconductor device, the conductive material comprises silver and the thermoplastic resin comprises thermoplastic polyimide. Therefore, adhesion with high heat-resisting property is performed.

According to a fourth aspect of the present invention, a fabricating method of a semiconductor device comprises: plating thermoplastic resin including particles comprising conductive material on a first main surface of a semiconductor substrate; and hardening the thermoplastic resin thereby to form a thin film thermoplastic conductive resin layer. Therefore, positional deviations of the semiconductor device with the resin layer while die-bonding the semiconductor device is dispensed with, thereby increasing the fabrication yield. In addition, an apparatus and a process for disposing resin on a package can be omitted, thereby the die-bonding can be performed at a low cost.

According to a fifth aspect of the present invention, in the above-described fabricating method of a semiconductor device, the process of plating conductive resin comprises dropping thermoplastic resin including particles comprising conductive material, with rotating the semiconductor substrate in a plane parallel with the first main surface of the semiconductor substrate. Therefore, it is possible to form a uniform and thin thermoplastic resin film, thereby the heat conductivity between the semiconductor device and the die-pad is improved.

According to a sixth aspect of the present invention, in the above-described fabricating method of a semiconductor device, the process of forming the thermoplastic conductive resin layer is performed by making the second main surface which is opposite to the first main surface of the semiconductor substrate adhere to a rotating plate which holds and rotates the semiconductor substrate without exposing its opposite first main surface to the external air. Therefore, the contaminations on the surface of the semiconductor device due to gases which are generated by the solvent included in the thermo-plastic resin material before the surface of the semiconductor device is hardened can be prevented.

According to a seventh aspect of the present invention, in the above-described fabricating method of a semiconductor device, the semiconductor substrate is in a wafer shape and the method further includes, after forming the thermoplastic conductive resin layer, separating the wafer shape substrate into chips. Therefore, a plurality of semiconductor devices each provided with thermo-plastic conductive resin layer at its rear surface can be obtained at one time.

According to an eighth aspect of the present invention, in the above-described fabricating method of a semiconductor layer, the conductive material comprises silver and the thermoplastic resin comprises thermoplastic polyimide. Therefore, adhesion with high heat-resisting property is performed.

According to a ninth aspect of the present invention, a die-bonding method of a semiconductor device comprises: forming a semiconductor device comprising a semiconductor substrate having a first main surface and a thermoplastic conductive resin layer comprising thermoplastic resin including particles comprising conductive material disposed on the first main surface of the semiconductor substrate; holding a supporting member on which the semiconductor substrate is to be die-bonded, at a temperature higher than the glass transition temperature of the thermoplastic conductive resin layer; and applying pressure to the semiconductor device with making the first main surface of the semiconductor substrate on which the thermoplastic conductive resin layer is provided directed toward the supporting member to make the semiconductor device adhere to the supporting member. Therefore, the process of setting the resin layer on a mounting plate of the package for mounting a semiconductor device can be omitted, and the die-bonding process can be simplified, thereby enhancing the productivity.

### BRIEF DESCRIPTION OF THE DRAWINGS

Figure 1 is a cross-sectional view illustrating a structure of a semiconductor device according to a first embodiment of the present invention.

Figure 2 is a diagram for explaining the die-bonding method utilized in the fabricating method of a semiconductor device according to the first embodiment of the present invention.

Figures 3(a)-3(e) are process diagrams illustrating a fabricating method of a semiconductor device according to a first embodiment of the present invention.

Figures 4(a)-4(c) are diagrams illustrating a prior art die-bonding method of a semiconductor device.

Figures 5(a)-5(b) are diagrams illustrating another prior art die-bonding method of a semiconductor device which can solve the problems in the prior art example described with reference to figures 4(a)-4(c).

### DETAILED DESCRIPTION OF THE PREFERRED EMBODIMENT

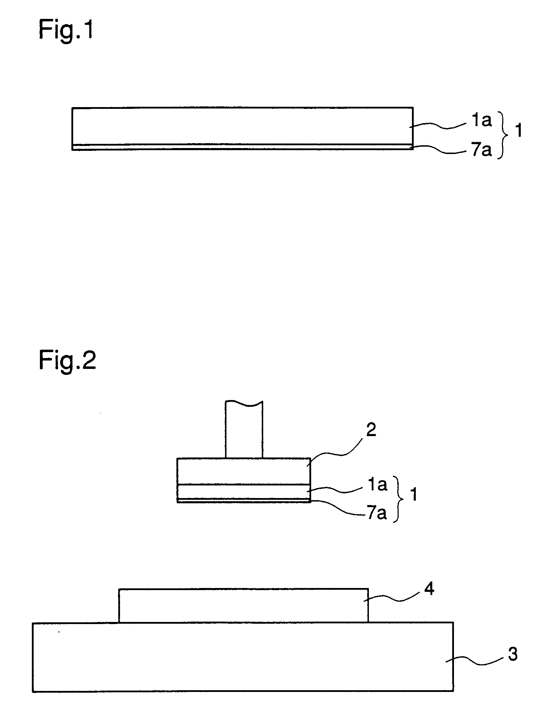

Figure 1 is a cross-sectional view illustrating a structure of a semiconductor device according to a first embodiment of the present invention. In the figure, numeral 1a designates a semiconductor chip which is cut out from a wafer (not shown). This semiconductor chip comprises a single or a plurality of semiconductor elements formed on a semiconductor substrate. Numeral 7a designates a thermoplastic polyimide resin layer including particles comprising conductive material, disposed on the rear surface of the semiconductor chip 1a. In this embodiment, as the particles comprising conductive material, silver particles in a scale shape having a thickness of 0.5 ∼ 3 µm and having an area of several tens square µm, or silver particles in a spherical shape of a diameter of several µm are used, and the quantity thereof is adjusted as required. Besides, the resistance of the thermoplastic conductive polyimide resin layer 7a of this embodiment is 10⁻⁴∼10⁻⁶ Ωcm, and the thermal conductivity thereof is 10⁻³∼10⁻¹ cal/cm·sec°C.

Figure 2 is a diagram for explaining a die-bonding method utilized in the fabricating method of a semiconductor device according to the first embodiment of the present invention. In the figure, the same reference numerals designate the same or corresponding elements. Numeral 2 designates a collet for moving the semiconductor device 1 which is absorbed to the collet 2 itself. This collet 2 is provided with a vacuum absorbing means for absorbing the semiconductor device 1. Numeral 3 designates a heat stage provided with a heating means inside thereof. Numeral 4 designates a die-pad serving as a part of the package sealing the semiconductor device 100. The semiconductor device 1 is adhered onto the die-pad 4.

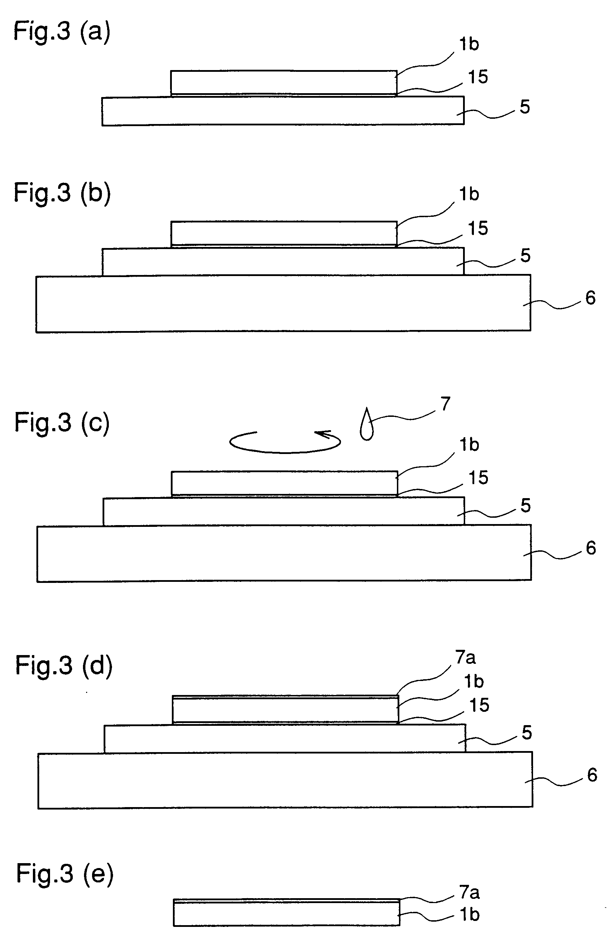

Figures 3(a)-3(e) are process diagrams illustrating a fabricating method of a semiconductor device according to a first embodiment of the present invention. In the figure, the same reference numerals designate the same or corresponding elements. Numeral 1b designates a semiconductor substrate in a wafer shape on which a plurality of elements (not shown in the figure) are disposed. Numeral 5 designates a glass plate. Numeral 15 designates a wax for fixing the semiconductor device. Numeral 6 designates a mounting plate of a spin coater (not shown) similar as that used in the usual photoresist plating process, and this plating plate 6 is rotatable in the horizontal direction and a vacuum absorbing means (not shown) for vacuum absorbing the wafer is provided on the surface. Numeral 7 designates thermoplastic conductive resin paste comprising the resin of the same material as the thermoplastic conductive polyimide resin layer 7a including the conductive material and the solvent.

A description is given of the fabricating method with reference to figures 3(a)-3(e). First of all, as shown in figure 3(a), the surface of the wafer 1b on which elements are formed and the glass plate 5 are adhered with each other using wax 15, this is mounted on the mounting plate 6, and it is vacuum absorbed to be fixed to the mounting plate 6 (figure 3(b)). Next, by the spin coating method which is generally used in the resist plating process, a polyimide resin layer is formed on the wafer 1. That is, as shown in figure 3(c), while rotating the mounting plate 6 and the wafer 1a with together, the thermoplastic conductive polyimide resin paste 7 is dropped and it is made a uniform thin film by utilizing the centrifugal force, and it is heated and dried to obtain the thermoplastic conductive polyimide resin layer 7a on the rear surface of the wafer 1b (figure 3(d)). Thereafter, the wafer 1b which has the thermoplastic conductive polyimide resin layer 7a on its rear surface is removed from the glass plate 5 by melting the wax 15 (figure 3(e)). Thereafter, the surface of the wafer 1b which has the thermoplastic conductive polyimide resin layer 7a thereon is fixed to a UV (ultraviolet) tape (not shown) whose adhesion intensity is reduced by that the ultraviolet light is irradiated, and thereafter, the wafer 1b is separated into chips by dicing. Thereafter, ultraviolet light is irradiated to the UV tape thereby to reduce the adhesion, and the semiconductor devices are removed from the UV tape into respective separated chips, thereby obtaining the semiconductor devices 1 each provided with the thermoplastic conductive polyimide resin layer 7a on its surface.

The die-bonding method of a semiconductor device according to this embodiment will be described. As shown in figure 2, the surface of the semiconductor substrate 1 which is opposite to the surface of the semiconductor device 1 on which the thermoplastic conductive polyimide resin layer 7a is provided, is held absorbed by such as a collet 2. This is pressed to a position on the die-pad 4 where a semiconductor device is to be placed. This die-pad 4 is previously heated to a temperature a little higher than the glass transition temperature of thermoplastic conductive polyimide resin layer, for example, about 210°C for the resin layer having a glass transition temperature of 200°C. The thermoplastic conductive polyimide resin layer 7a of the semiconductor device is softened by the heat of the die-pad 4, thereby die-bonding the semiconductor device 1 on the die-pad. The die-pad 4 is heated in this embodiment by a heating means provided inside the heat stage 3, but as a method for heating the die-pad 4, a high frequency heating or other method may be used.

In the semiconductor device of this embodiment, since the thermoplastic conductive polyimide resin layer 7a is provided on the surface of the substrate of the semiconductor device, there arises no positional deviation of the semiconductor device while attaching the semiconductor device to the die-pad 4 with relative to the thermoplastic conductive resin, and the die-bonding having the desired heat radiation property, conductivity, and intensity can be performed, and the fabrication yield can be enhanced. In addition, the thermoplastic conductive resin layer and the semiconductor device have the same sizes, thereby providing no positional deviation with each other. Therefore, the size of the package can be made one that is minimized in accordance with the size of the semiconductor device.

In addition, it is not necessary to provide an apparatus for plating resin paste or an apparatus disposing resin pellet with the die-bonding apparatus, and the fabricating apparatus can be simplified and the fabricating cost can be reduced. Further, since no processes are required to plate resin paste on respective packages mounting the semiconductor substrate or to dispose resin pellet, the fabricating process can be simplified and the productivity can be enhanced.

Further, the thermoplastic conductive polyimide resin layer 7a can be formed to a uniform thickness and have a controlled thin thickness by a spin coating method, and therefore, the heat conductivity between the semiconductor chip 1a and the die-pad 1 after the die-bonding can be enhanced.

In addition, since a plurality of semiconductor devices 1 are obtained by cutting the wafer 1b into respective elements after the thermoplastic conductive polyimide resin layer 7a is formed at the rear surface of the wafer 1b, a plurality of semiconductor devices 1 each provided with the thermoplastic conductive polyimide resin layer 7a on its rear surface can be obtained at once, thereby increasing the productivity of semiconductor devices.

In addition, since thermoplastic resin is used as resin for die-bonding before the bonding of the semiconductor device 1, solvent is already evaporated from the thermoplastic conductive polyimide resin paste 7 similarly as in the other prior art. Therefore, the semiconductor device is not affected by the gases which are generated by the evaporation of the solvents. In addition, differently from the case where the semiconductor device 1 is fixed to the resin paste, the resin would not crawl up onto the upper surface from the side surface of the semiconductor device 1, thereby not deteriorating the fabrication yield. Further, since the thermoplastic resin would hardly transform after it is hardened, after it is plated onto the rear surface of the semiconductor device 1, the holding and handling thereof are easy. Further. since the polyimide resin has thermal decomposition starting temperature of above 400 °C, no decomposition and deformation occur even at a high temperature processing in the later process such as the wire bonding, whereby the above-described problems as in the prior art die-bonding method are solved.

While in the above-embodiment the thermoplastic conductive resin layer 7a is formed by using a spin coating method, since the surface of such as elements of the wafer 1b is sticked to the glass plate 5, the surface of the wafer 1b would not be contaminated by gasses which are generated by the evaporation of the solvent.

According to this first embodiment of the present invention, since after the thermoplastic conductive polyimide resin layer 7 is formed on a rear surface of a wafer by spin coating method, and this is separated for respective elements, the semiconductor devices 1 each provided with the thermoplastic conductive polyimide resin layer 7a at its rear surface are obtained. Therefore, it is possible to make the positional deviation between the semiconductor device and the resin layer in the die-bonding process dispensed with and the die-bonding can be performed at a high yield. Accordingly, the apparatus and the process for plating resin paste can be omitted in the die-bonding process. Therefore, the fabricating apparatus and fabricating process are simplified, and the die-bonding can be performed at low cost and at high productivity.

While in the above-described embodiment, the thermoplastic polyimide resin is employed as the thermoplastic resin, the present invention can be applied to cases even when the other thermoplastic resin is used, and the same effects as in the above-described embodiment are obtained. In a case where the high temperature processing such as wire bonding is performed in the later process, it is preferable to use thermoplastic resin having a glass transition temperature which is not softened by the high temperature processing.

In the above-described embodiment, the thermoplastic conductive polyimide resin layer is formed on a wafer shaped semiconductor substrate on which a plurality of elements are formed by using a spin coating method, and thereafter, respective elements are cut out from the wafer to be the semiconductor devices. In the present invention, however, as a semiconductor substrate, a wafer on which a lot of elements are formed may be used, and after the thermoplastic conductive polyimide resin layer 7a is formed thereon, the wafer may be used for die-bonding without cut out into respective chips. Alternatively, a semiconductor substrate on which no elements are formed may be used. In that case, the thermoplastic conductive polyimide resin layer is formed on the surface of the substrate, elements are formed on the opposite surface thereof, and the wafer is cut out into chips or it may be used for the die-bonding as it is, with the same effects as described above.

## Claims

1. A semiconductor device comprising (Fig. 1):
a semiconductor substrate (1a) having a first main surface;
a thermoplastic conductive resin layer (7a) comprising thermoplastic resin including particles comprising conductive material disposed on the first main surface of the semiconductor substrate (1a).

2. The semiconductor device of claim 1 (Fig. 3(e)) wherein the semiconductor substrate (1b) has an element disposed on its second main surface opposite to the first main surface.

3. The semiconductor device of claim 1 wherein the conductive material comprises silver and the thermoplastic resin comprises thermoplastic polyimide.

4. A fabricating method of a semiconductor device comprising (Fig. 1):
plating thermoplastic resin (7a) including particles comprising conductive material on a first main surface of a semiconductor substrate (1a); and
hardening the thermoplastic resin (7a) thereby to form a thin film thermoplastic conductive resin layer (7a).

5. The fabricating method of a semiconductor device of claim 4 (Figs. 3(a)-3(e)) wherein the process of plating conductive resin comprises dropping thermoplastic resin (7) including particles comprising conductive material, with rotating the semiconductor substrate (1b) in a plane parallel with the first main surface of the semiconductor substrate (1b).

6. The fabricating method of a semiconductor device of claim 5 (Fig. 2) wherein the process of forming the thermoplastic conductive resin layer (7a) is performed by making the second main surface which is opposite to the first main surface of the semiconductor substrate (1b) adhere to a rotating plate (2) which holds and rotates the semiconductor substrate (1b) without exposing the opposite surface to the external air.

7. The fabricating method of a semiconductor device of claim 4 (Figs. 3(a)-3(e)) further comprising:
the semiconductor substrate (1b) being in a wafer shape: and
after forming the thermoplastic conductive resin layer (7), separating the wafer shape substrate (1b) into chips.

8. The fabricating method of a semiconductor layer of claim 4 (Figs. 3(a)-3(e)) wherein the conductive material comprises silver and the thermoplastic resin comprises thermoplastic polyimide.

9. A die-bonding method of a semiconductor device comprising (Fig. 1):
forming a semiconductor device comprising a semiconductor substrate (1b) having a first main surface and a thermoplastic conductive resin layer (7a) comprising thermoplastic resin including particles comprising conductive material disposed on the first main surface of the semiconductor substrate (1a);
holding a supporting member on which the semiconductor substrate (1b) is to be die-bonded at a temperature higher than the glass transition temperature of the thermoplastic conductive resin layer(7); and
applying pressure to the semiconductor device with making the first main surface of the semiconductor substrate (1b) on which the thermoplastic conductive resin layer (7a) is provided directed toward the supporting member to make the semiconductor device adhere to the supporting member.
